# EUROPÄISCHE PATENTSCHRIFT

(11) **EP 1 066 534 B1**
(45) Veröffentlichungstag und Bekanntmachung des Hinweises auf die Patenterteilung: **18.06.2003**
(21) Anmeldenummer: 99914515.4
(22) Anmeldetag: 12.03.1999
(51) Int. Cl.: G01R 27/28, H03L 7/099

(54) **VEKTORIELLER NETZWERKANALYSATOR**
VECTOR NETWORK ANALYSER
ANALYSEUR VECTORIEL DE RESEAU

(30) Priorität: 23.03.1998 DE 19812604
(43) Veröffentlichungstag der Anmeldung: 10.01.2001
(73) Patentinhaber: Forschungszentrum Karlsruhe GmbH, 76133 Karlsruhe (DE)
(72) Erfinder: ARNOLD, Andreas, D-76131 Karlsruhe (DE); BRAZ, Oliver, D-89173 Lonsee (DE); KUNKEL, Hans, D-76131 Karlsruhe (DE); THUMM, Manfred, D-76351 Linkenheim-Hochstetten (DE)
(86) Internationale Anmeldenummer: EP9901622
(87) Internationale Veröffentlichungsnummer: WO99049326

(56) Entgegenhaltungen:
- GB-A- 2 197 143
- US-A- 5 119 035
- GOY P: "A full-coverage 16-216 GHz (and above) millimeter scalar network analyzer" MIOP '88: MICROWAVES AND OPTOELECTRONICS. CONFERENCE PROCEEDINGS, WIESBADEN, WEST GERMANY, 2-4 MARCH 1988, Seiten 1A-7/1-6, XP002108220 ISBN 3-924651-15-9, 1988, Hagenburg, West Germany, Network, West Germany

## Beschreibung

Die Erfindung betrifft einen vektoriellen Netzwerkanalysator für den Millimeterwellenbereich. Ein solcher besteht aus einer Millimeterwellenquelle, erster Oszillator, mit Sendeeinrichtung und einer Mikrowellenempfangseinrichtung. Zur Meßwertgewinnung wird ein Teil des Sendesignals aus dem zur Sendeantenne führenden Hohlleiter ausgekoppelt und zum Meßsignal für ein Vektorvoltmeter heruntergemischt. Es handelt sich um hochfrequente Ausgangssignale im mm-Wellenlängenbereich, die phasen- und amplitudengetreu auf Frequenzen zur weiteren Auswertung geeignet heruntergesetzt werden. Die Lokaloszillationen werden beim Abwärtsmischen vom Referenzoszillator abgeleitet.

Das Hauptproblem bei der Netzwerkanalyse im Millimeterwellenbereich ist die geeignete Millimeterwellenquelle. Unter Verwendung schmalbandiger Überlagerungsempfänger (Heterodyn-Verfahren) ist es möglich, Signale bis auf einige dB an die physikalische Rauschgrenze (Pₙₒᵢₛₑ = kTB, bei B = 1 Hz und T = 273 K sind das - 174 dBm) zu bestimmen. Die untere Nachweisgrenze hängt somit hauptsächlich von der Bandbreite des Empfangsfilters ab. Die maximale, mit diesem frequenzselektiven Filter, von der Quelle noch zu erfassende Leistung hängt von der in der Empfangsbandbreite enthaltenen spektralen Leistungsdichte und deren Frequenzstabilität ab.

Die Grundidee ist in der US 5,119,035 A beschrieben. Die durch Vervielfachung erzeugte Millimeterwellenfrequenz, sowie die zum Heruntermischen des Empfangssignals benötigten "Pumpsignale" werden aus zwei 8 - 18 GHz- Oszillatoren abgeleitet. Um einen für die vektorielle Messung notwendigen Phasenbezug zwischen beiden YIG-gesteuerten Transistoroszillatoren zu erreichen, sind beide über eine Phasenregelschleife an eine Referenzquelle phasenstarr angekoppelt. Wie beim skalaren Aufbau ist der erreichbare Meßumfang stark durch die Effizienz der verwendeten Vervielfacher beschränkt. Dieser wird mit 70 - 80 dB im D-Band angegeben.

Die Weiterentwicklung dieses Konzepts betrifft ein uber die Versorgungsspannung phasenstabilisierter Gunn-Oszillator. Dieser hat eine Schwäche: zwar liefern die verwendeten Halbleiteroszillatoren Ausgangsleistungen von einigen 10 mW, doch ist deren elektrisch durchstimmbarer Frequenzbereich stark durch den dabei benötigten mechanischen Resonanzraum eingeschränkt. Beispielweise beträgt dieser Frequenzbereich bei einem Gunn-Oszillator mit einer Mittenfrequenz von 144 GHz lediglich 5 GHz. Hinzu kommt, daß solche Oszillatoren auf Indium-Phosphit-Basis mit brauchbaren Ausgangsleistungen lediglich bis 150 GHz kommerziell erhältlich sind. Der Versuch, eine freilaufende Rückwärtswellenröhre (RWO bzw. engl. BWO) zu verwenden, kommt wegen der damit verbundenen schlechten Frequenzauflösung nicht in Betracht.

Der Erfindung liegt die Aufgabe zugrunde, mit kommerziell erhältlichen Komponenten einen vektoriellen Netzwerkanalysator mit hoher Dynamik im Bereich von 70 - 190 GHz bereitzustellen, mit dem ein Netzwerk unter Einwirkung von Millimeterwellen über eine hohem Meßumfang bzw. weiten Wellenlängenbereich untersucht werden kann.

*Die Aufgabe wird durch einen vektoriellen Netzwerkanalysator gemäß Anspruch 1 gelöst. Das Kernstück des Netzwerkanalysators ist eine Phasenregelschleife, die die erste Millimeterwellenquelle an eine dritte frequenzstabile Referenzquelle anbindet*. *Bei Verwendung eines Quarzoszillators (Anspruch 3) als Referenzquelle bildet die Quarzreferenz das Referenzsignal.*

*Die erste Millimeterwellenquelle ist eine Elektronenlaufzeitröhre, die aufgrund ihrer Parameter die Sendebandbreite festlegt. Aus der Gruppe der einsetzbaren Laufzeitröhren hat sich der Rückwärtswellenonszillator, RWO oder engl. BWO, bewährt (Anspruch* *9), bei ihm z.B. wird die Schwingfrequenz über die Beschleunigungsspannung eingestellt*.

Die dafür notwendigen Netzgeräte haben einen hohen Anteil an Störspannungen wie Netzbrummen und Reste der Spannungsregelung, die sich direkt auf das Spektrum des Ausgangssignals auswirken. Selbst wenn die Beschleunigungsspannung brummfrei wäre, führt thermisches Ausdehnen der Verzögerungsstruktur im Falle des ersten Oszillators als Röhre zum Driften der Frequenz. Um diese Störungen auszugleichen, wird dem Netzgerät für die Beschleunigungsspannung eine von ihm unabhängige kleine, in ihrer Amplitude schnell regelbare Gleichspannungsquelle in Reihe geschaltet. Die Regelgröße wird aus dem abwärtsgemischten Teilsignal des Sendesignals durch Phasenvergleich mit dem Referenzsignal aus dem Referenzoszillator gebildet, wobei ein Tiefpaß und Vestärker dazwischen geschaltet sind (Anspruch 8). Bei passender Einstellung der Regelparameter wird die spektrale Breite von einigen Megahertz Bandbreite auf weniger als 100 Hz ausgeregelt. Zusammen mit einem Empfänger kleiner Empfangsbandbreite wird ein vektorieller Netzwerkanalysator hoher Dynamik realisiert.

Der festfrequente Referenzoszillator taktet den Mikrowellenoszillator oder die Mikrowellenoszillatoren, die den Lokaloszillator für die Abwärtsmischung bilden, und ist damit maßgebend für die Abwärtsmischung oder die Stufen der Abwärtsmischung überhaupt (Ansprüche 2 und 4). Die entsprechenden Abwärtsstufen im sende- und empfangsseitigen Superheterodyn-Empfänger können gleich oder verschieden sein (Ansprüche 4 und 5). Wichtig ist, daß am Ende der Abwärtsmischung die Frequenz des festfrequenten Referenzoszillators erreicht wird.

Entscheidend für das Übersprechen trotz verschiedener erster Zwischenfrequenzlagen, ist die räumliche Trennung der beiden Superheterodyn-Empfänger, da sich in beiden bei gleicher mehrfacher Abwärtsstufung noch weitere Zwischenfrequenzstufen gleicher Frequenz befinden. Auch die getrennte Aufbereitung teils gleicher Lokaloszillatorfrequenzen in beiden mehrstufigen Superheterodyn-Empfänger verhindert ein direktes Übersprechen. Bei gleichen ersten Zwischenfrequenzlagen ist zu berücksichtigen, daß der sende- und empfangsseitige erste Mischer über einen Verstärker mit hoher Isolation, gleichbedeutend ist hohe Rückwärtsdämpfung, betrieben werden. Die Isolation entspricht normalerweise mindestens der Verstärkung (Anspruch 6). Gleichzeitig dürfen diese Verstärker nicht so breitbandig sein, daß die erste Zwischenfrequenz (im Ausführungsbeispiel 640 MHz) noch nennenswert verstärkt wird (Ansprüche 6 und 7).

Um eine hohe Dynamik bei gleichzeitig hoher Empfindlichkeit zu erreichen, wäre eigentlich die Hauptverstärkung auf die niedrigste Zwischenfrequenz zu legen. Damit ginge aber der Nachteil einher, daß das unvermeidliche Übersprechen der Referenzfrequenz auch sehr hoch verstärkt wird. Das hätte eine starke Einschränkung der Dynamik zur Folge.

Die Vorteile des vektoriellen Netzwerkanalysators bestehen darin, daß eine vollständige elektronische Steuerung aufgebaut werden kann und damit mechanische Resonatoren entfallen. Frequenzdriften der Rückwärtswellenröhre durch Temperaturgang und/oder Alterung wird durch den Phasen- und Frequenzdiskriminator und das daraus abgeleitete Regelsignal ausgeglichen. Unter Verwendung ein paar weniger Rückwärtswellenoszillatoren - im Gegensatz zu Halbleiteroszillatoren wie Gunndioden - ist der gesamte mm-Wellenbereich abzudecken. Schon mit einem D-Band-Rückwärtswellenoszillator wird das halbe W-, das D- und das halbe G-Band abgedeckt. Das Schaltungskonzept läßt sich prinzipiell auf alle erhältlichen Rückwärtswellenoszillatoren anwenden. Da keine Sonderentwicklung von speziellen Hochfrequenzbaukomponenten nötig ist und der Bedarf aus kommerziell erhältlichen Komponenten gedeckt werden kann, ist der Netzwerkanalystor mit guter Leistungsfähigkeit zu einem wirtschaftlichen Preis herzustellen.

Ein Ausführungsbeispiel der Erfindung wird im folgenden anhand der Zeichnung näher erläutert. Es zeigen:
Figur 1 das Blockschaltbild des vektoriellen Netzwerkanalysators,
Figur 2a Frequenzspektrum des frei laufenden Rückwärtswellenoszillators,
Figur 2b Frequenzspektrum des phasenstabilisierten Rückwärtswellenoszillators und
Figur 3 den gemessenen Meßumfang D in dB des vektoriellen Netzwerkanalysators.

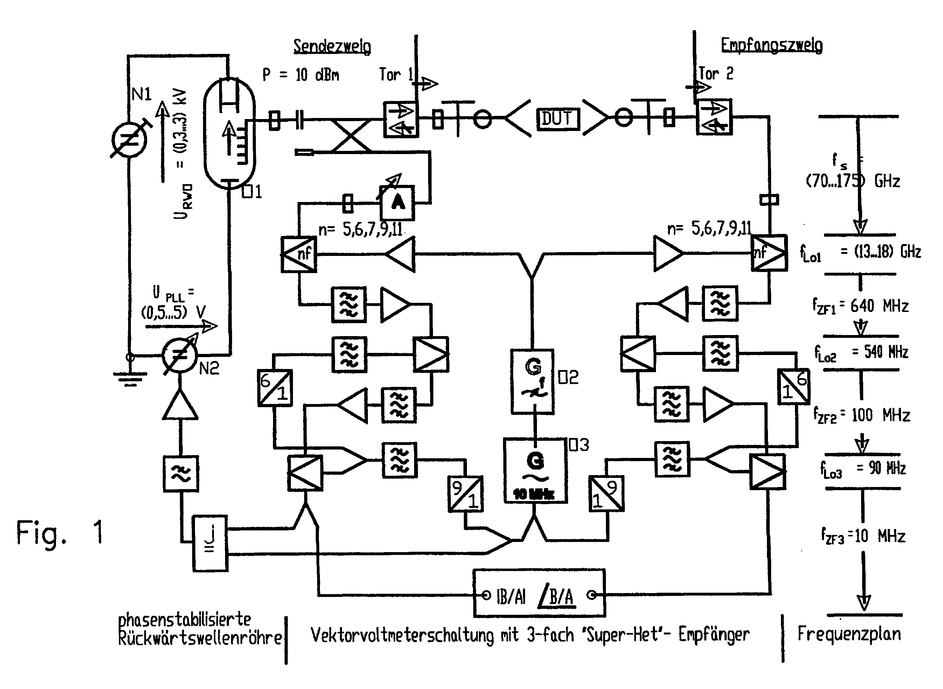

Das Ausführungsbeispiel gemäß Figur 1 zeigt den blockartigen Aufbau des vektoriellen Netzwerkanalysators für die Vermessung des zu untersuchenden Netzwerks (DUT = Device Under Test). Mit dem Netzwerkanalysator kann von 70 - 175 GHz nach Phase und Betrag bzw. nach dem Betrag des Verhältnisses von Sende- zu Empfangssignal gemessen werden. Somit ist das W-, D-Band und mehr als die Hälfte des G-Bandes mit dem verwendeten Rückwärtswellenoszillator (RWO oder im engl. Sprachraum BWO) abgedeckt. Sende- als auch empfangsseitig ist der dreifach Superheterodyn-Empfänger mit jeweils gleicher Abstufung im Abwärtsmischen eingebaut. Damit wird eine schmale Bandbreite bei gleichzeitig hoher Verstärkung erreicht.

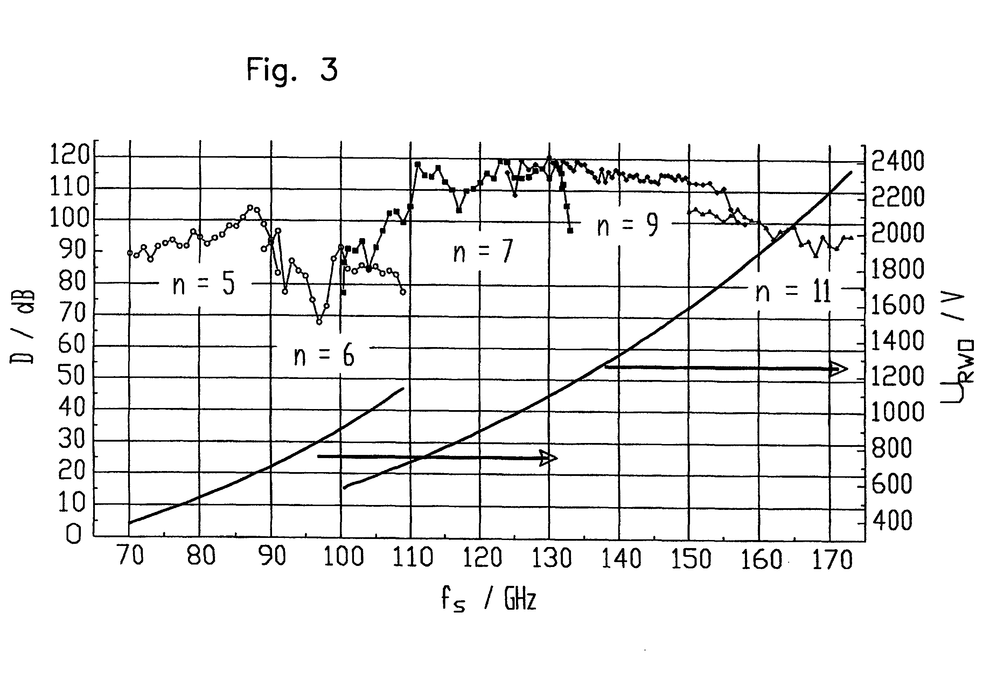

Das für die Analyse notwendige Band wird durch den ersten Millimeterwellenoszillator O₁ und den Betrieb des ersten Abwärtsmischers in beiden Superheterodyn-Empfängern auf die entsprechende Harmonische n (Figur 3) festgelegt. Die große Bandbreite erfordert den weit durchstimmbaren, leistungsstarken Rückwärtswellenoszillator O₁. Die Hauptabstimmung der Frequenz wird über die zwischen der Kathode und Anode liegenden Beschleunigungsspannung U_{RWO} = 0.3 - 3.0 kV geregelt, die über das Netzgerät N₁ zwischen Kathode und Anode anliegt. Schwankungen der Beschleunigungsspannung aufgrund des apparativen Aufbaus oder thermisches Driften der Röhre O₁ werden nach Grobeinstelleung über N₁ vollends genau über das unabhängige, zu Netzteil N₁ in Reihe geschaltete Netzteil N₂ fein ausgeregelt. Daher ist seine Regelamplitude höchstens gleich der maximal zu erwartenden Schwankung des Netzteils N₁, nämlich U_{PLL} = 0.5 - 5V.

Die Regelung des zweiten Netzgeräts N₂ erfolgt phasengebunden, indem die festfrequente 10 MHz-Schwingung aus der Quarzreferenz O₃ mit dem Ausgang des heruntergemischten Sendesignalanteils verglichen und über den Tiefpaß als Regelfilter und nachfolgenden Verstärker dem Regeleingang des kleinen Netzgerätes zugeführt wird. Dadurch ist die Rückwärtswellenröhre O₁ phasenstabilisiert.

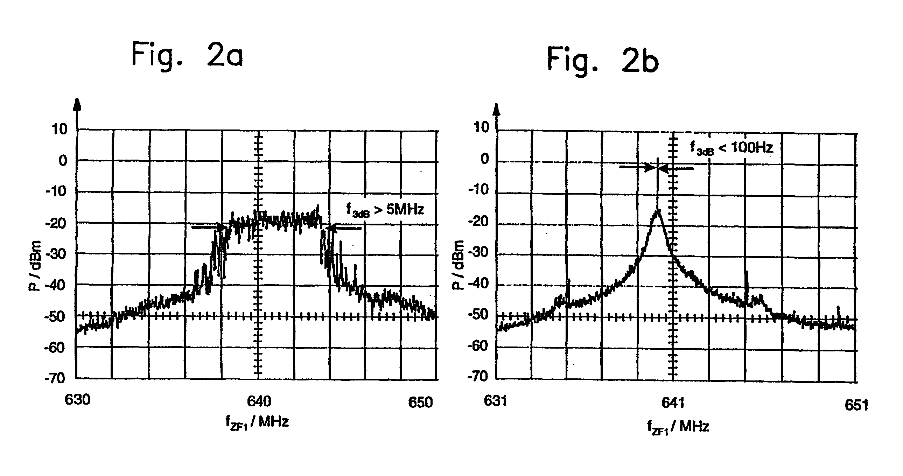

Die Wirksamkeit der Maßnahme demonstrieren Figur 2a und 2b. In ihnen ist das Frequenzspektrum der auf die erste Zwischenfrequenz von 640 MHz umgesetzten Millimeterwellenausgangsleistung der Rückwärtswellenröhre bei fₛ = 140 GHz dargestellt. Die Bandbreite der 3 dB Grenze beträgt mindestens 5 MHz im frei laufenden Fall, hingegen tritt mit der phasenstabilisierten Rückwärtswellenröhre eine Bandbreite von f_{3 dB} < 100 Hz auf.

Der Frequenzplan ist der Blockschaltung in Figur 1 zur Seite gestellt und zeigt das dreistufige, gleichartige Heruntermischen von 70 - 175 GHz über die Zwischenfrequenzen f_{ZF1} = 640 MHz und f_{ZF2} = 100 MHz auf f_{ZF3} = 10 MHz im Sende- als auch Empfangsbereich. Die in den Figur 1 und 3 angeschriebene Zahlen 5, 6, 7, 9 und 11 bezeichnen dabei die jeweilige Harmonische der durch den Mikrowellenoszillator O₂ gegebenen Grundwelle, die zur Frequenzumsetzung in dem jeweiligen Oberwellenmischer verwendet werden. Ein Oberwellenmischer kann durchaus auf mehreren Harmonischen betrieben werden, so wird zur Abwärtsmischung des vollständigen D-Bandes nur ein Mischer (n = 7, 9 und 11) verwendet.

Figur 3 zeigt den mit Hilfe eines W- und D-Band-Rückwärtswellenoszillators ermittelten Meßumfang D. Ein Wechsel des RW-Oszillators sowie des ersten Mischers ist bei einer Frequenz von ca 100 GHz aufgrund des durch die Abmessungen des jeweiligen Hohlleiters bedingten Einschränkung der Frequenz (cut-off) unumgänglich. Die beiden unteren Kurvenzüge, jeweils mit einem nach rechts weisenden Pfeil versehen, zeigen die für die eingestellte Sendefrequenz fₛ nötige Beschleunigungsspannung U_{RWO} und deren Verlauf beim jeweils verwendeten Rückwärtswellenoszillator.

## Patentansprüche

1. Vektorieller Netzwerkanalysator für den Millimeterwellenbereich, bestehend aus:
- einem ersten Millimeterwellenoszillator (O₁) mit Sendeeinrichtung,
- einem Millimeterwellen-Empfänger mit einer ersten Einrichtung zum Abwärtsmischen des *am Ausgang eines zu untersuchenden Netzwerks DUT, device under test, ausgekoppelten* Empfangssignals,
- einer zweiten Einrichtung zum Abwärtsmischen des über eine Auskoppeleinrichtung abgezweigten Teils des *auf den Eingang des DUT gerichteten* Sendesignals,
- mindestens einem weiteren Mikrowellenoszillator (O₂) für das Abwärtsmischen des Sende- und Empfangssignals, der Lokaloszillator ist,
- einem zusätzlichen festfrequenten Referenzoszillator (O₃), der Phasenreferenz ist,
- einem Hochfrequenz-Vektor-Empfänger *als Anzeigevorrichtung* und daran gekoppelten Einrichtungen zur Darstellung der Eigenschaften *des* zwischen der Sende- und Empfangseinrichtung zur *Untersuchung exponierten DUT,*
**dadurch gekennzeichnet, daß**
*der erste Millimeterwellenoszillator (O*_{*1*}*) eine Elektronenlaufzeltröhre ist, und daß einem in seiner Ausgangsspannung steuerbaren ersten Netzgerät (N*_{*1*}*) zur Erzeugung der Beschleunigungsspannung für den ersten Millimeterwellenozillator (O*_{*1*}*) ein regelbares zweites Netzgerät (N*_{*2*}*) in Reihe geschaltet ist, das unabhängig von der Beschleunigungsspannung ist,*
der Regeleingang des zweiten Netzgeräts (N₂) mit dem Ausgang eines Phasen- und Frequenzdiskriminators verbunden ist, an dessen einen Eingang das Referenzsignal des festfrequenten Referenzoszillators (O₃) und an dessen anderen Eingang der Ausgang *der sendeseitigen, zweiten Einrichtung zum Abwärtsmischen* gelegt ist, wobei das abwärts gemischte Sendesignal die gleiche Frequenz wie das Referenzsignal hat.

2. Vektorieller Netzwerkanalysator für den Millimeterwellenbereich nach Anspruch 1,
**dadurch gekennzeichnet, daß**
der festfrequente Referenzoszillator (O₃) die Millimeterwellenoszillatoren (O₁ und O₂) taktet und damit Lokaloszillator für die sende- und empfangsseitigen Abwärtsmischer ist.

3. Vektorieller Netzwerkanalysator für den Millimeterwellenbereich nach Anspruch 2,
**dadurch gekennzeichnet, daß**
der festfrequente Referenzoszillator (O₃) ein Quarzoszillator ist.

4. Vektorieller Netzwerkanalysator für den Millimeterwellenbereich nach Anspruch 3,
**dadurch gekennzeichnet, daß**
*die sende- und empfangsseitige Einrichtung zum Abwärtsmischen auf die Frequenz des Referenzsignals jeweils einstufig ist*.

5. Vektorieller Netzwerkanalysator für den Millimeterwellenbereich nach Anspruch 3,
**dadurch gekennzeichnet, daß**
*die sende- und empfangsseitige Einrichtung zum Abwärtsmischen auf die Frequenz des Referenzsignals jeweils mindestens zweistufig ist und beide im allgemeinen verschieden abwärtsmischen.*

6. Vektorieller Netzwerkanalysator für den Millimeterwellenbereich nach Anspruch 5,
**dadurch gekennzeichnet, daß** jeweils
ein Verstärker mit hoher Isolation die erste Mischstufe der beiden Empfänger betreibt und die Isolation mindestens gleich der Verstärkung ist.

7. Vektorieller Netzwerkanalysator für den Millimeterwellenbereich nach Anspruch 6,
**dadurch gekennzeichnet, daß**
der erste Zwischenfrequenzverstärker im empfangsseitigen Abwärtsmischer so rauscharm ist, daß *das Rauschmaß* NF ≤ 5 dB eingehalten wird.

8. Vektorieller Netzwerkanalysator für den Millimeterwellenbereich nach den Ansprüchen 4 *und 7,*
**dadurch gekennzeichnet, daß**
der Regeleingang des zweiten Netzgeräts (N₂) über einen Verstärker und ein Tiefpaßfilter mit dem Ausgang des Phasen- und Frequenzdiskriminators verbunden ist.

9. Vektorieller Netzwerkanalysator für den Millimeterwellenbereich nach Anspruch 8,
**dadurch gekennzeichnet, daß**
die erste Millimeterwellenquelle ein Rückwärtswellenoszillator ist.

## Claims

1. Vector network analyser for the millimetre wave range, comprising:
- a first millimetre wave oscillator (O₁) with a transmitting apparatus,
- a millimetre wave receiver with a first apparatus for the downward mixing of the received signal, which is decoupled at the output of a network DUT, device under test, to be examined,
- a second apparatus for the downward mixing of the part, branched-off via a decoupling apparatus, of the transmitted signal directed to the input of the DUT,
- at least one further microwave oscillator (O₂) for the downward mixing of the transmitted signal and received signal, which is the local oscillator,
- an additional fixed-frequency reference oscillator (O₃), which is the phase reference,
- a high-frequency vector receiver as the indicating device and apparatus, connected thereto, to display the properties of the DUT which is exposed for examination between the transmitting apparatus and receiving apparatus,
**characterised in that** the first millimetre wave oscillator (O₁) is an electron transit-time tube, and **in that** there is connected in series with a first power supply (N₁), which is controllable in its output voltage for generating the acceleration voltage for the first millimetre wave oscillator (O₁), a controllable second power supply (N₂) which is independent of the acceleration voltage, the control input of the second power supply (N₂) is connected to the output of a phase and frequency discriminator, the reference signal of the fixed-frequency reference oscillator (O₃) being placed at one input of said discriminator, and the output of the second apparatus, on the transmitting side, for downward mixing being placed at the other input of said discriminator, the downwardly mixed transmitted signal having the same frequency as the reference signal.

2. Vector network analyser for the millimetre wave range according to claim 1, **characterised in that** the fixed-frequency reference oscillator (O₃) times the millimetre wave oscillators (O₁ and O₂) and is, therefore, the local oscillator for the downward mixers on the transmitting and receiving sides.

3. Vector network analyser for the millimetre wave range according to claim 2, **characterised in that** the fixed-frequency reference oscillator (O₃) is a quartz oscillator.

4. Vector network analyser for the millimetre wave range according to claim 3, **characterised in that** each apparatus, on the transmitting and receiving sides, for downward mixing to the frequency of the reference signal has one stage.

5. Vector network analyser for the millimetre wave range according to claim 3, **characterised in that** each apparatus, on the transmitting and receiving sides, for downward mixing to the frequency of the reference signal has at least two stages, and both generally mix downwardly in different manners.

6. Vector network analyser for the millimetre wave range according to claim 5, **characterised in that** an amplifier with a high level of insulation operates the first mixing stage of each of the two receivers, and the insulation is at least equal to the amplification.

7. Vector network analyser for the millimetre wave range according to claim 6, **characterised in that** the first intermediate frequency amplifier in the downward mixer on the receiving side has so little noise that the noise figure NF is maintained at ≤ 5 dB.

8. Vector network analyser for the millimetre wave range according to claims 4 and 7, **characterised in that** the control input of the second power supply (N₂) is connected to the output of the phase and frequency discriminator via an amplifier and a low-pass filter.

9. Vector network analyser for the millimetre wave range according to claim 8, **characterised in that** the first millimetre wave source is a backward wave oscillator.

## Revendications

1. Analyseur vectoriel de réseau pour une plage d'ondes millimétriques comprenant :
- un premier oscillateur à ondes millimétriques (O₁) avec une installation d'émission,
- un récepteur à ondes millimétriques avec une première installation pour un mélange inverse du signal de réception découplé de la sortie d'un réseau à analyser (DUT),
- une seconde installation pour le mélange inverse de la partie du signal d'émission envoyé à l'entrée du réseau (DUT), dérivé par une installation de découplage,
- au moins un autre oscillateur à micro-ondes (O₂) pour le mélange inverse du signal d'émission et du signal de réception, cet oscillateur étant un oscillateur local,
- un oscillateur de référence (O₃) fixe supplémentaire qui donne une référence de phase,
- un récepteur vectoriel haute fréquence comme dispositif d'affichage auquel est couplée une installation pour représenter les propriétés du réseau (DUT) exposées pour l'analyse entre l'installation d'émission et de réception,
**caractérisé en ce que**
le premier oscillateur à ondes millimétriques (O₁) est un tube à temps de transit d'électrons et pour créer une tension d'accélération pour le premier oscillateur à ondes millimétriques (O₁) un second appareil de réseau (N₂) réglable, est branché en série, sur un premier appareil de réseau (N₁) dont la tension de sortie est commandée cet appareil étant indépendant de la tension d'accélération, l'entrée de régulation du second appareil de réseau (N₂) étant reliée à un discriminateur de phase et de fréquence dont une entrée reçoit le signal de référence de l'oscillateur de référence fixe (O₃) et dont l'autre entrée est reliée à la sortie de la seconde installation, du côté de l'émission pour un mélange inverse, et le signal d'émission obtenu par mélange inverse a la même fréquence que le signal de référence.

2. Analyseur vectoriel de réseau pour la plage des ondes millimétriques selon la revendication 1,
**caractérisé en ce que**
l'oscillateur de référence, de fréquence fixe (O₃) commande la cadence des oscillateurs à ondes millimétriques (O₁, O₂) et réalise ainsi le mélange descendant avec l'oscillateur local, pour le mélange inverse du côté de l'émission et de la réception.

3. Analyseur vectoriel de réseau selon la revendication 2,
**caractérisé en ce que**
l'oscillateur de référence de fréquence fixe (O₃) est un oscillateur à quartz.

4. Analyseur vectoriel de réseau selon la revendication 3,
**caractérisé en ce que**
l'installation du côté de l'émission et de la réception pour le mélange inverse sur la fréquence du signal de référence, est chaque fois à un seul étage.

5. Analyseur vectoriel de réseau selon la revendication 3,
**caractérisé en ce que**
l'installation du côté de l'émission et de la réception pour le mélange inverse à la fréquence du signal de référence travaille chaque fois avec au moins deux étages, dont les deux en assurent le mélange inverse différemment de manière générale.

6. Analyseur vectoriel de réseau selon la revendication 5,
**caractérisé en ce qu'**
il est prévu chaque fois un amplificateur à isolation poussée qui pilote le premier étage de mélange des deux récepteurs et l'isolation est au moins égale au coefficient d'amplification.

7. Analyseur vectoriel de réseau selon la revendication 6,
**caractérisé en ce que**
le premier amplificateur de fréquence intermédiaire du mélangeur inverse du côté de la réception a un bruit tellement faible que l'on respecte la mesure du bruit NF ≤ 5 dB.

8. Analyseur vectoriel de réseau selon les revendications 4 et 7,
**caractérisé en ce que**
l'entrée de régulation du second appareil de réseau (N₂) est reliée par un amplificateur et un filtre passe-bas à la sortie du discriminateur de phase et de fréquence.

9. Analyseur vectoriel de réseau selon la revendication 8,
**caractérisé en ce que**
la première source d'ondes millimétriques est un oscillateur à onde inverse.
